# EUROPEAN PATENT APPLICATION

(11) **EP 4 746 275 A1**
(43) Date of publication of application: **20.05.2026**
(21) Application number: 24855244.0
(22) Date of filing: 06.03.2024
(51) Int. Cl.: H02M 7/00

(54) **INVERTER AND HEAT SINK**

(30) Priority: 24.08.2023 CN 202311077255
(71) Applicant: Huawei Digital Power Technologies Co., Ltd., Shenzhen, Guangdong 518043 (CN)
(72) Inventor: REN, Junheng, Shenzhen, Guangdong 518043 (CN); HONG, Fangjun, Shenzhen, Guangdong 518043 (CN); LI, Jiyang, Shenzhen, Guangdong 518043 (CN)
(74) Representative: Gill Jennings & Every LLP
(86) International application number: PCT/CN2024/080387
(87) International publication number: WO 2025/039513

(57) **Abstract**

This application provides an inverter and a heat apparatus, and relates to the field of energy technologies, to resolve a technical problem of poor heat dissipation effect of an inverter. The inverter provided in this application includes a circuit board, a power module, and a heat apparatus. The heat apparatus includes an evaporator, a condenser, and a cooling medium. The evaporator is in heat-conducting connection to the power module. The evaporator has an evaporation chamber, the condenser has a condensation channel and an air flow channel, the condensation channel has a first end opening and a second end opening that face away from each other, a gas discharge opening communicates with the first end opening, a liquid return opening communicates with the second end opening, and the condensation channel is parallel to the air flow channel. In the inverter provided in this application, temperature of the evaporator can be reduced through heat absorption and vaporization of the liquid cooling medium in the evaporator, to improve efficiency in heat transfer between the power module and the evaporator. The air flow channel and the condensation channel are parallel to each other, to improve efficiency in heat exchange between air and the cooling medium, and improve heat dissipation performance of the heat apparatus.

## Description

### CROSS-REFERENCE TO RELATED APPLICATIONS

This application claims priority to Chinese Patent Application No. 202311077255.3, filed with the China National Intellectual Property Administration on August 24, 2023 and entitled "INVERTER AND HEAT APPARATUS", which is incorporated herein by reference in its entirety.

### TECHNICAL FIELD

This application relates to the field of energy technologies, and in particular, to an inverter and a heat apparatus.

### BACKGROUND

With continuous development and wide application of green energy, importance of electric energy in people's daily life has become increasingly prominent. In a process of transmitting or using electric energy, a parameter such as a voltage or a current of the electric energy needs to be converted or adjusted. For example, a photovoltaic power generation device may include a solar panel and an inverter. The solar panel can convert solar energy into a direct current, and the inverter can convert the direct current generated by the solar panel into an alternating current and then output the alternating current to the outside. During actual use, the inverter generates a large quantity of heat. Therefore, heat needs to be dissipated for the inverter, to ensure operating performance and reliability of the inverter. Currently, air cooling is mainly used to dissipate heat for the inverter. In simple terms, a heat apparatus can be disposed on an outer surface of the inverter, heat of the inverter can be conducted to the heat apparatus through heat transfer, and external airflow can take away heat of the heat apparatus when flowing through a surface of the heat apparatus, to cool the inverter. However, as operating power of the inverter continuously increases, heat dissipation requirements of the inverter also significantly increase. Consequently, simply using the air cooling heat apparatus to dissipate heat for the inverter cannot satisfy the heat dissipation requirements of the inverter. Therefore, how to improve heat dissipation performance of the inverter has become an urgent technical problem to be resolved.

### SUMMARY

This application provides an inverter and a heat apparatus that have good heat dissipation performance.

According to a first aspect, this application provides an inverter. The inverter includes a circuit board, a power module, and a heat apparatus. The power module is disposed on the circuit board and is electrically connected to a conductive line in the circuit board. The power module is configured to adjust a parameter such as a voltage and/or a current of electric energy, and the heat apparatus is configured to cool the power module. The heat apparatus may include an evaporator, a condenser, and a cooling medium. A heat-conducting surface of the evaporator is in heat-conducting connection to the power module, so that heat of the power module can be conducted to the evaporator through heat transfer. The evaporator has an evaporation chamber, a gas discharge opening, and a liquid return opening, and the gas discharge opening and the liquid return opening communicate with the evaporation chamber. The condenser includes a condensation tube assembly. The condensation tube assembly has a condensation channel and an air flow channel, the cooling medium is in the evaporation chamber and the condensation channel, and the air flow channel is configured to provide a channel for external air. The condensation channel has a first end opening and a second end opening that face away from each other, the condensation channel extends from the first end opening to the second end opening, the gas discharge opening communicates with the first end opening, and the liquid return opening communicates with the second end opening. The air flow channel has a first air vent and a second air vent that face away from each other, and the air flow channel extends from the first air vent to the second air vent. The first end opening and the first air vent are located on a first side of the condensation tube assembly, the second end opening and the second air vent are located on a second side of the condensation tube assembly, and an extension direction of the condensation channel is parallel to an extension direction of the air flow channel. In the inverter provided in this application, temperature of the evaporator can be reduced through heat absorption and vaporization of the liquid cooling medium in the evaporator, to improve efficiency in heat transfer between the power module and the evaporator. In addition, the gaseous cooling medium condenses and releases heat in the condenser, so that heat of the evaporator is effectively transferred to the condenser. In addition, air can quickly take away heat of the condenser when flowing in the air flow channel of the evaporator, to accelerate condensation of the cooling medium in a condensation tube. This can effectively improve circulation efficiency of the cooling medium. In addition, the air flow channel and the condensation channel are parallel to each other, to improve efficiency in heat exchange between the air and the cooling medium, and improve heat dissipation performance of the heat apparatus. In addition, the heat-conducting surface is parallel to both the extension direction of the air flow channel and the extension direction of the condensation channel, so that position interference between the power module and the condenser can be avoided, and the power module can be prevented from blocking or interfering with the air flow channel, to have good convenience of use and ensure heat dissipation performance of the heat apparatus.

In an example, the condensation tube assembly includes a plurality of condensation tubes disposed at spacings, each condensation tube has the condensation channel, and the air flow channel is formed between two adjacent condensation tubes. During manufacturing of the condensation tube assembly, condensation tubes may be separately manufactured and formed, and then a plurality of formed condensation tubes are assembled into the condensation tube assembly. This can effectively reduce manufacturing difficulty.

During specific disposition, the condensation tube may be rectangular and plate-shaped, and the condensation channel runs through two ends of the condensation tube that face away from each other. The plurality of condensation tubes are disposed at spacings in a first direction, and the first direction is perpendicular to a plate surface of the condensation tube. The foregoing structure disposition is used, so that there is a large heat exchange area between the condensation tube and the air flow channel. This helps ensure heat dissipation efficiency of the condensation tube.

In an example, the condensation tube assembly further includes a sealing plate, the sealing plate is located between two adjacent condensation tubes, one end of the sealing plate extends to the first air vent, and the other end extends to the second air vent. The two adjacent condensation tubes and the sealing plate can jointly form a closed air flow channel, to ensure flow effect of airflow.

In an example, the condenser further includes a first flow-combining plate, and the first flow-combining plate is disposed on the first side of the condensation tube assembly. The first flow-combining plate has a first flow-combining chamber, a first flow-combining opening, and a plurality of first flow-dividing openings, the first flow-combining opening communicates with the gas discharge opening, the plurality of first flow-dividing openings are aligned with and communicate with a plurality of first end openings in a one-to-one correspondence, and the first flow-combining opening and the first flow-dividing openings communicate with the first flow-combining chamber. The first flow-combining plate can connect the evaporation chamber to a plurality of condensation channels, and have effective flow-dividing effect on the cooling medium, so that the cooling medium discharged from the gas discharge opening of the evaporator can be effectively distributed to the condensation channels. In addition, the first flow-combining plate can provide the first flow-combining chamber of a large volume, and the first flow-combining chamber can accommodate a large amount of gaseous cooling medium. This helps reduce a volume of the evaporator.

In an example, the first flow-combining plate further has a first breather hole that runs through a thickness of the first flow-combining plate, and the first air vent is aligned with and communicates with the first breather hole. During actual use, air can enter the air flow channel through the first breather hole, or air in the air flow channel can be discharged from the first breather hole, to ensure flow efficiency of air in the air flow channel, and avoid adverse impact such as obstruction of air flow caused by the first flow-combining plate.

In an example, the gas discharge opening may be aligned with and communicate with the first flow-combining opening directly, to implement communication between the first flow-combining opening and the gas discharge opening. This can avoid use of a connection tube between the evaporator and the condenser, and help reduce manufacturing costs of the heat apparatus and facilitate installation.

Alternatively, the heat apparatus may further include a first connection tube, one end of the first connection tube is aligned with and communicates with the gas discharge opening, and the other end is aligned with and communicates with the first flow-combining opening. That is, the first connection tube can implement communication between the first flow-combining opening and the gas discharge opening.

In an example, the condenser further includes a second flow-combining plate, and the second flow-combining plate is disposed on the second side of the condensation tube assembly. The second flow-combining plate has a second flow-combining chamber, a second flow-combining opening, and a plurality of second flow-dividing openings, the second flow-combining opening communicates with the liquid return opening, the plurality of second flow-dividing openings are aligned with and communicate with a plurality of second end openings in a one-to-one correspondence, and the second flow-combining opening and the second flow-dividing openings communicate with the second flow-combining chamber. The second flow-combining plate can connect the evaporation chamber to the plurality of condensation channels, and have effective flow-combining effect on the cooling medium, so that the cooling medium discharged from the condensation channels can effectively flow back to the evaporation chamber through the second flow-combining plate. In addition, the second flow-combining plate can provide the second flow-combining chamber of a large volume, and the second flow-combining chamber can accommodate a large amount of liquid cooling medium. This helps reduce the volume of the evaporator.

In an example, the second flow-combining plate further has a second breather hole that runs through a thickness of the second flow-combining plate, and the second air vent is aligned with and communicates with the second breather hole. During actual use, air can enter the air flow channel through the second breather hole, or air in the air flow channel can be discharged from the second breather hole, to ensure flow efficiency of air in the air flow channel, and avoid adverse impact such as obstruction of air flow caused by the second flow-combining plate.

In an example, the liquid return opening may be aligned with and communicate with the second flow-combining opening directly, to implement communication between the second flow-combining opening and the liquid return opening. This can avoid use of a connection tube between the evaporator and the condenser, and help reduce manufacturing costs of the heat apparatus and facilitate installation.

Alternatively, the heat apparatus may further include a second connection tube, one end of the second connection tube is aligned with and communicates with the liquid return opening, and the other end is aligned with and communicates with the second flow-combining opening. That is, the second connection tube can implement communication between the second flow-combining opening and the liquid return opening.

In an example, a capillary structure is disposed in the evaporation chamber, and a projection of the capillary structure covers the heat-conducting surface. The capillary structure can effectively adsorb the cooling medium, and prevent the heat-conducting surface from experiencing a bad case such as dry heat.

In an example, the condensation tube assembly may further have a heat dissipation fin, and the heat dissipation fin is located in the air flow channel and connected to an outer surface of the condensation tube. Heat of the condensation tube can be effectively transferred to the heat dissipation fin through heat conduction. The heat dissipation fin has a large heat exchange area, and air flowing through a cooling channel can quickly take away heat of the heat dissipation fin, so that condensation efficiency of the cooling medium in the condensation channel can be effectively improved.

In an example, the condensation tube assembly may have an extension section disposed toward the evaporator, and the extension section is in heat-conducting contact with the evaporator. The extension section is disposed, so that heat of the evaporator can be conducted to the condensation tube assembly through heat transfer, and heat dissipation efficiency of the evaporator can be effectively improved.

In an example, the heat apparatus further includes a fan, and the fan can increase a flow speed of air in the air flow channel. The fan may be disposed on a first side or a second side of the condenser, or fans may be disposed on both the first side and the second side of the condenser.

According to a second aspect, this application provides a heat apparatus. An evaporator has an evaporation chamber, a gas discharge opening, and a liquid return opening, and the gas discharge opening and the liquid return opening communicate with the evaporation chamber. A condenser includes a condensation tube assembly. The condensation tube assembly has a condensation channel and an air flow channel, a cooling medium is in the evaporation chamber and the condensation channel, and the air flow channel is configured to provide a channel for external air. The condensation channel has a first end opening and a second end opening that face away from each other, the gas discharge opening communicates with the first end opening, and the liquid return opening communicates with the second end opening. The air flow channel has a first air vent and a second air vent that face away from each other, the first end opening and the first air vent are located on a first side of the condensation tube assembly, the second end opening and the second air vent are located on a second side of the condensation tube assembly, and an extension direction of the condensation channel is parallel to an extension direction of the air flow channel. In the heat apparatus provided in this application, temperature of the evaporator can be reduced through heat absorption and vaporization of the liquid cooling medium in the evaporator, to improve efficiency in heat transfer between a to-be-dissipated component and the evaporator. In addition, heat of the evaporator can be effectively transferred to the condenser through condensation and heat release of the gaseous cooling medium in the condenser. In addition, air can quickly take away heat of the condenser when flowing in the air flow channel of the evaporator, to accelerate condensation of the cooling medium in a condensation tube. This can effectively improve circulation efficiency of the cooling medium. In addition, the extension direction of the air flow channel and the extension direction of the condensation channel are parallel to each other, to improve efficiency in heat exchange between the air and the cooling medium, and improve heat dissipation performance of the heat apparatus.

### BRIEF DESCRIPTION OF DRAWINGS

FIG. 1 is a simple diagram of a structure of a conventional photovoltaic power generation device according to an embodiment of this application;
FIG. 2 is a diagram of a partial structure of an inverter according to an embodiment of this application;
FIG. 3 is a diagram of a structure of a heat apparatus according to an embodiment of this application;
FIG. 4 is a diagram of a structure of another heat apparatus according to an embodiment of this application;
FIG. 5 is a diagram of a three-dimensional structure of a heat apparatus according to an embodiment of this application;
FIG. 6 is a diagram of an exploded structure of a heat apparatus according to an embodiment of this application;
FIG. 7 is a diagram of a cross-sectional structure of a heat apparatus according to an embodiment of this application;
FIG. 8 is a diagram of a cross-sectional structure of a condensation tube according to an embodiment of this application;
FIG. 9 is a diagram of another cross-sectional structure of a heat apparatus according to an embodiment of this application;
FIG. 10 is a diagram of a structure of a condensation tube according to an embodiment of this application;
FIG. 11 is a diagram of a structure of another heat apparatus according to an embodiment of this application;
FIG. 12 is a diagram of a structure of another heat apparatus according to an embodiment of this application;
FIG. 13 is a diagram of a structure of another heat apparatus according to an embodiment of this application;
FIG. 14 is a diagram of a structure of another heat apparatus according to an embodiment of this application; and
FIG. 15 is a block diagram of a structure of a photovoltaic system according to an embodiment of this application.

### DESCRIPTION OF EMBODIMENTS

To make objectives, technical solutions, and advantages of this application clearer, the following further describes this application in detail with reference to accompanying drawings.

For ease of understanding a heat apparatus provided in embodiments of this application, the following first describes an application scenario of the heat apparatus.

The heat apparatus provided in embodiments of this application may be used in a plurality of scenarios in which there is a heat dissipation requirement, and is configured to cool a to-be-dissipated component, so that the to-be-dissipated component is in a normal temperature range, to ensure operating performance and safety of the to-be-dissipated component.

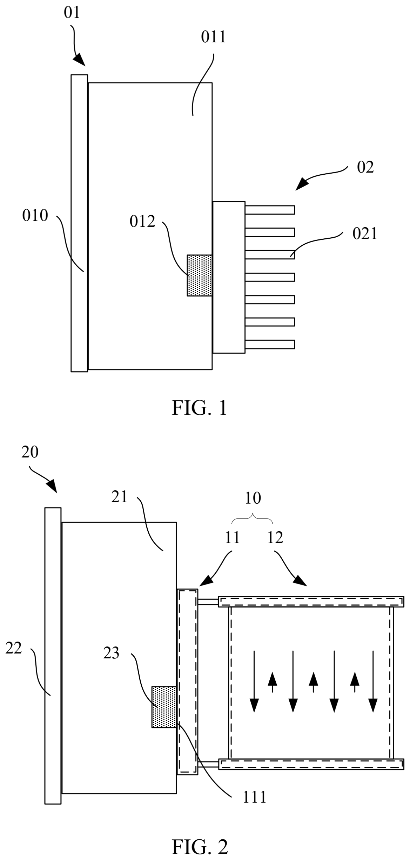

For example, as shown in FIG. 1, a photovoltaic power generation device may include an inverter 01. The inverter 01 can convert a direct current generated by a solar panel into an alternating current and then output the alternating current to the outside. During actual use, the inverter 01 may include a circuit board 010 and a power module 011. The power module 011 is disposed on the circuit board 010 and is electrically connected to a conductive line in the circuit board 010. The power module 011 may include a component such as a power transistor 012. During actual application, the power module 011 generates a large quantity of heat. Therefore, heat needs to be dissipated for the power module 011 of the inverter 01, to ensure operating performance and reliability of the inverter 01. Currently, air cooling is mainly used to dissipate heat for the power module 011. In simple terms, a heat apparatus 02 can be disposed at a position, on the power module 011, corresponding to the power transistor 012. The heat apparatus 02 may include heat dissipation fins 021. Airflow can quickly take away heat of the heat dissipation fins 021 when flowing through a gap between the heat dissipation fins 021, to cool the power module 011. In summary, heat generated by the power module 011 can be transferred to the heat apparatus fins 021 of the heat apparatus 02 through heat conduction, and airflow flowing through the heat dissipation fins 021 can quickly take away heat of the heat apparatus 02, to cool the power module 011.

However, as operating power of the inverter 01 continuously increases, heat dissipation requirements of the power module 011 also significantly increase. Consequently, simply using the air cooling heat apparatus 02 to dissipate heat for the power module 011 cannot satisfy the heat dissipation requirements of the power module 011.

Therefore, embodiments of this application provide an inverter with good heat dissipation performance.

To make the objectives, technical solutions, and advantages of this application clearer, the following further describes this application in detail with reference to the accompanying drawings and specific embodiments.

As shown in FIG. 2, in an example provided in this application, an inverter 20 includes a power module 21, a circuit board 22, and a heat apparatus 10. The power module 21 is disposed on the circuit board 22 and is electrically connected to a conductive line in the circuit board 22. The power module 21 is configured to adjust a parameter, for example, a voltage and/or a current, of electric energy at an input end, and then output an adjusted parameter from an output end. A housing 21 is in heat-conducting contact with a side that is of the power module 21 and that faces away from the circuit board 22, and the heat apparatus 10 is located outside the housing 21 and is configured to cool the power module 21. Specifically, an evaporator 11 of the heat apparatus 10 has a heat-conducting surface 111 that is in heat-conducting contact with the power module 21, and heat generated by the power module 21 can be effectively conducted to the heat-conducting surface 111 of the evaporator 11.

During actual application, the power module 21 is of a package structure, and power components 23 such as a power transistor and a power conversion circuit may be packaged inside the power module 21. Specific types and a quantity of power components 23 included in the power module 21 are not limited in this application.

In addition, during actual application, the inverter 20 may include a plurality of power modules 21, and each power module 21 may be in heat-conducting connection to the heat-conducting surface 111 of the evaporator 11. Alternatively, it may be understood that an outer surface of the evaporator 11 may have a plurality of heat-conducting surfaces 111, and each heat-conducting surface 111 may be in heat-conducting connection to a corresponding power module 21.

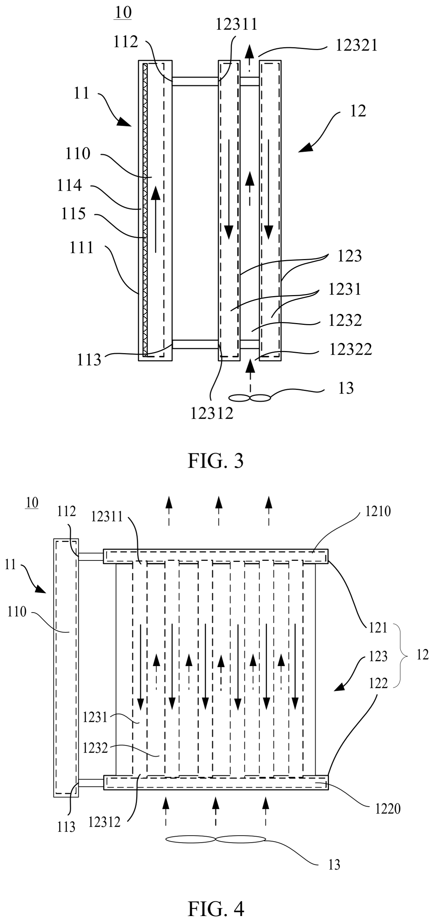

As shown in FIG. 3, during specific application, the heat apparatus 10 may include an evaporator 11, a condenser 12, and a cooling medium (not shown in FIG. 3). The evaporator 11 has an evaporation chamber 110, and an outer surface of the evaporator 11 has a heat-conducting surface 111 configured to be in heat-conducting contact with the power module 21. Heat generated by the power module 21 can be effectively transferred to the evaporator 11 through the heat-conducting surface 111. In addition, the heat apparatus 10 further includes the condenser 12. The cooling medium may circulate between the heat apparatus 10 and the condenser 12, so that heat of the heat apparatus 10 can be effectively dissipated through the condenser 12. Specifically, a gas discharge opening 112 and a liquid return opening 113 are provided on an outer surface of the evaporator 11, and both the gas discharge opening 112 and the liquid return opening 113 communicate with the evaporation chamber 110. The condenser 12 includes a condensation tube assembly 123, the condensation tube assembly 123 has a condensation channel 1231, and the condensation channel 1231 has a first end opening 12311 and a second end opening 12312 that face away from each other. The first end opening 12311 of the condensation channel 1231 communicates with the gas discharge opening 112, and the second end opening 12312 of the condensation channel 1231 communicates with the liquid return opening 113. The cooling medium may circulate in a path formed by the evaporation chamber 110 and the condensation channel 1231, and implement mutual conversion between a gas phase and a liquid phase of the cooling medium, so that heat of the evaporator 11 can be effectively transferred to the condensation tube assembly 123 of the condenser 12. In addition, the condensation tube assembly 123 further has an air flow channel 1232, and the air flow channel 1232 is configured to provide a channel for external air. The air flow channel 1232 has a first air vent 12321 and a second air vent 12322 that face away from each other. Both the first end opening 12311 of the condensation channel 1231 and the first air vent 12321 of the air flow channel 1232 are located on a first side (for example, an upper side shown in FIG. 3) of the condensation tube assembly 123, both the second end opening 12312 of the condensation channel 1231 and the second air vent 12322 of the air flow channel 1232 are located on a second side (for example, a lower side shown in FIG. 3) of the condensation tube assembly 123, and an extension direction of the air flow channel 1232 is parallel to an extension direction of the condensation channel 1231. External air can quickly take away heat of the condensation tube assembly 123 when flowing through the air flow channel 1232, to reduce heat of the condensation tube assembly 123. This can increase a cooling speed when the cooling medium flows in the condensation channel 1231.

In the heat apparatus 10 provided in this application, the heat-conducting surface 111 is provided, so that heat of the power module 21 can be effectively transferred to the evaporator 11 through heat transfer for heat dissipation. In addition, the cooling medium is in the evaporation chamber 110 of the evaporator 11. The liquid cooling medium absorbs heat and vaporizes in the evaporation chamber 110, so that temperature of the evaporator 11 can be effectively reduced, to ensure performance of heat transfer between the power module 21 and the heat apparatus 10. A vaporized cooling medium may flow to the condensation channel 1231 of the condensation tube assembly 123 through the gas discharge opening 112 of the evaporator 11. The cooling medium flowing through the condensation channel 1231 and the air flowing through the air flow channel 1232 exchange heat with each other in the condensation tube assembly 123, so that temperature of the cooling medium can be effectively reduced. After the temperature of the cooling medium is reduced, the cooling medium condenses, and flows back to the evaporation chamber 110 through the liquid return opening 113. In this way, the cooling medium circulates between the evaporation chamber 110 and the condensation channel 1231, and heat dissipation performance is good.

In summary, in the heat apparatus 10 provided in this application, temperature of the evaporator 11 can be reduced through heat absorption and vaporization of the liquid cooling medium in the evaporator 11, to improve efficiency in heat transfer between the power module 21 and the evaporator 11. In addition, heat of the evaporator 11 can be effectively transferred to the condenser 12 through condensation and heat release of the gaseous cooling medium in the condenser 12. In addition, air can quickly take away heat of the condenser 12 when flowing in the air flow channel 1232 of the evaporator 11, to accelerate condensation of the cooling medium in a condensation tube 1233. This can effectively improve circulation efficiency of the cooling medium. In addition, the extension direction of the air flow channel 1232 and the extension direction of the condensation channel 1231 are parallel to each other, to improve efficiency in heat exchange between the air and the cooling medium, and improve heat dissipation performance of the heat apparatus 10.

In addition, both the first end opening 12311 of the condensation channel 1231 and the first air vent 12321 of the air flow channel 1232 are located on the first side of the condensation tube assembly 123, both the second end opening 12312 of the condensation channel 1231 and the second air vent 12322 of the air flow channel 1232 are located on the second side of the condensation tube assembly 123, and the extension direction of the air flow channel 1232 is parallel to the extension direction of the condensation channel 1231. During actual use, both the condensation channel 1231 and the air flow channel 1232 may be in a vertical or nearly vertical attitude. This can effectively improve convenience of use and heat dissipation performance of the heat apparatus 10. Specifically, when the condensation channel 1231 is vertically disposed, the liquid cooling medium may have a high flow rate under effect of gravity. This helps improve flow-back efficiency of the cooling medium. In addition, according to a principle that hot air rises, when the air flow channel 1232 is vertically disposed, hot air may flow from bottom to top in the air flow channel 1232. This helps increase a flow speed of air in the air flow channel 1232, and helps improve heat dissipation efficiency of the condenser 12. During actual application, a fan 13 may be disposed at either end of the air flow channel 1232, to increase a flow speed of air in the air flow channel 1232.

It should be noted that, in the foregoing descriptions, that the extension direction of the air flow channel 1232 is parallel to the extension direction of the condensation channel 1231 means that the extension direction of the air flow channel 1232 and the extension direction of the condensation channel 1231 are parallel or nearly parallel to each other, or there may be an included angle between the air flow channel 1232 and the condensation channel 1231, in other words, the air flow channel 1232 and the condensation channel 1231 are not perpendicular to each other. In the example provided in this application, unless otherwise specified, a solid-line arrow in the figure indicates a flow path of the cooling medium, and a dashed-line arrow indicates a flow path of air.

During specific disposition, there are various manners for a specific position of the heat-conducting surface 111 on the evaporator 11.

For example, as shown in FIG. 2 and FIG. 3, in the example provided in this application, the heat-conducting surface 111 of the heat apparatus 10 is parallel to both the extension direction of the condensation channel 1231 and the extension direction of the air flow channel 1232. After the heat-conducting surface 111 is thermally attached to the power module 21, position interference between the power module 21 and the condenser 12 can be avoided, and the power module 21 can be prevented from blocking or interfering with the air flow channel 1232. In this way, convenience of use is good and heat dissipation performance of the heat apparatus 10 is ensured.

Specifically, as shown in FIG. 3, in the example provided in this application, the heat-conducting surface 111 is located on a first side wall 114 that is of the evaporator 11 and that faces away from the condenser 12. During actual use, an entire outer surface of the first side wall 114 may be used as the heat-conducting surface 111. Alternatively, a part of the outer surface may be used as the heat-conducting surface 111. When the part of the outer surface is used as the heat-conducting surface 111, the heat-conducting surface 111 may be located in an area close to the liquid return opening 113, or in the evaporation chamber 110, a liquid surface of the liquid cooling medium may be higher than an area in which the heat-conducting surface 111 is located. In this way, heat transferred through the heat-conducting surface 111 can be effectively received by the liquid cooling medium, to accelerate vaporization of the liquid cooling medium.

Alternatively, during specific disposition, a capillary structure 115 may be disposed on an inner surface of the first side wall 114, and a projection of the capillary structure 115 covers the heat-conducting surface 111.

As shown in FIG. 3, in the example provided in this application, the capillary structure 115 is disposed on the entire inner surface of the first side wall 114. Under effect of capillary suction, the capillary structure 115 can be effectively filled with the cooling medium. Therefore, the liquid cooling medium can effectively vaporize when any part of the outer surface of the first side wall 114 is used as the heat-conducting surface 111, so that heat dissipation performance of the evaporator 11 can be ensured, and a bad case such as dry heat can be effectively avoided.

It may be understood that, during actual use, a side (for example, a lower side or an upper side shown in FIG. 3) of the evaporator 11 may also be used as the heat-conducting surface 111. The specific position of the heat-conducting surface 111 is not limited in this application.

In addition, in the example provided in this application, the evaporator 11 is of a hollow plate-shaped structure. However, in another example, the evaporator 11 may alternatively be of a rectangular or column-shaped hollow structure, or the like. A specific shape of the evaporator 11 is not limited in this application.

In addition, during actual application, the condenser 12 may have various specific structure types.

For example, as shown in FIG. 4, in an example provided in this application, the condensation tube assembly 123 has a plurality of condensation channels 1231 (six condensation channels are shown in FIG. 4), and each condensation channel 1231 has a first end opening 12311 and a second end opening 12312. In addition, each first end opening 12311 communicates with the gas discharge opening 112, and each second end opening 12312 communicates with the liquid return opening 113.

For ease of communication between the plurality of condensation channels 1231 and the evaporation chamber 110, in the example provided in this application, the condenser 12 further has a first flow-combining chamber 1210 and a second flow-combining chamber 1220. The first flow-combining chamber 1210 connects the gas discharge opening 112 to a plurality of first end openings 12311, and is configured to implement communication between the gas discharge opening 112 and the plurality of first end openings 12311. The second flow-combining chamber 1220 connects the liquid return opening 113 to a plurality of second end openings 12312, and is configured to implement communication between the plurality of second end openings 12312 and the liquid return opening 113.

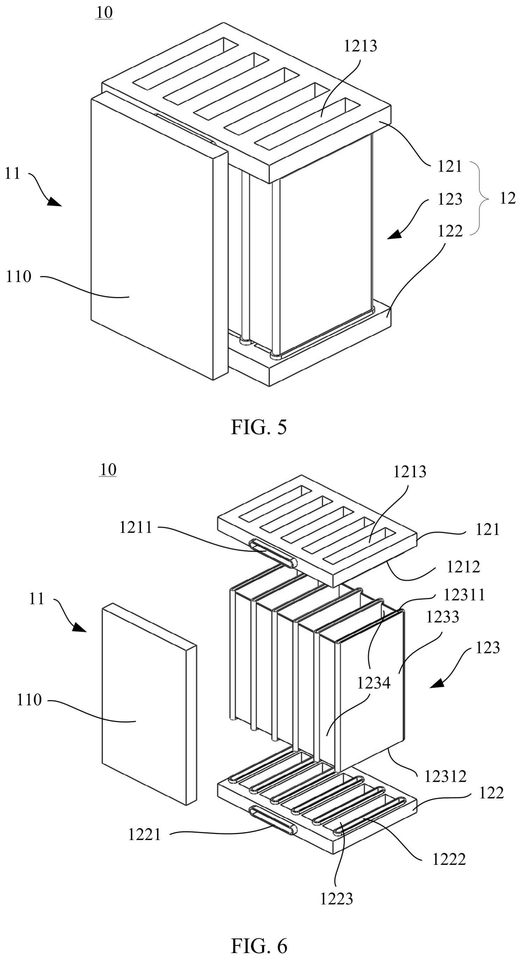

Specifically, as shown in FIG. 5, the condenser 12 includes a first flow-combining plate 121 and a second flow-combining plate 122 that are disposed opposite to each other.

Refer to FIG. 4, FIG. 5, and FIG. 6. The first flow-combining chamber 1210 is located in the first flow-combining plate 121, and the second flow-combining chamber 1220 is located in the second flow-combining plate 122. The first flow-combining plate 121 has a first flow-combining opening 1211 and a first flow-dividing opening 1212 that communicate with the first flow-combining chamber 1210, the second flow-combining plate 122 has a second flow-combining opening 1221 and a second flow-dividing opening 1222 that communicate with the second flow-combining chamber 1220, and the first flow-dividing opening 1212 and the second flow-dividing opening 1222 are disposed opposite to each other. The first flow-combining opening 1211 is configured to be aligned with and communicate with the gas discharge opening 112, and the second flow-combining opening 1221 is configured to be aligned with and communicate with the liquid return opening 113. The condensation tube assembly 123 is located between the first flow-combining plate 121 and the second flow-combining plate 122, the first end opening 12311 of the condensation channel 1231 is aligned with and communicates with a corresponding first flow-dividing opening 1212, and the second end opening 12312 of the condensation channel 1231 is aligned with and communicates with a second flow-dividing opening 1222.

The first flow-combining plate 121 can connect the evaporation chamber 110 to the plurality of condensation channels 1231, and have effective flow-dividing effect on the cooling medium, so that the cooling medium discharged from the gas discharge opening 112 of the evaporator 11 can be effectively distributed to the condensation channels 1231. The second flow-combining plate 122 can connect the evaporation chamber 110 to the plurality of condensation channels 1231, and have effective flow-combining effect on the cooling medium, so that the cooling medium discharged from the condensation channels 1231 can effectively flow back to the evaporation chamber 110 through the second flow-combining plate 122.

In addition, the first flow-combining plate 121 can provide the first flow-combining chamber 1210 of a large volume, and the first flow-combining chamber 1210 can accommodate a large amount of gaseous cooling medium. This helps reduce a volume of the evaporator 11. Alternatively, it may be understood that, during actual application, to ensure vaporization effect of the cooling medium, the entire evaporation chamber 110 cannot be fully filled with the cooling medium, otherwise it is not conducive to effective conversion from the liquid medium to the gaseous medium. In the example provided in this application, the first flow-combining chamber 1210 is provided, so that effective accommodation space can be provided for the gaseous cooling medium, to help reduce the volume of the evaporator 11, and ensure vaporization effect of the liquid cooling medium in the evaporation chamber 110.

In addition, the second flow-combining plate 122 can provide the second flow-combining chamber 1220 of a large volume, and the second flow-combining chamber 1220 can accommodate a large amount of liquid cooling medium. This helps reduce the volume of the evaporator 11. Alternatively, it may be understood that, during actual application, to ensure heat dissipation performance of the evaporator 11, a large evaporation chamber 110 needs to be provided in the evaporator 11 to ensure that there is sufficient cooling medium, to avoid a bad case such as dry heat. In the example provided in this application, the second flow-combining chamber 1220 is provided, so that effective accommodation space can be provided for the liquid cooling medium, and the liquid cooling medium can be effectively transferred to the evaporation chamber 110. This can effectively prevent the evaporator 11 from experiencing a bad case such as dry heat, and help reduce the volume of the evaporator 11.

As shown in FIG. 5, FIG. 6, and FIG. 7, the first flow-combining plate 121 further has a first breather hole 1213 that runs through a thickness of the first flow-combining plate 121, and the second flow-combining plate 122 further has a second breather hole 1223 that runs through a thickness of the second flow-combining plate 122. The first air vent 12321 of the air flow channel 1232 is aligned with and communicates with the first breather hole 1213, and the second air vent 12322 of the air flow channel 1232 is aligned with and communicates with the second breather hole 1223. During actual use, air can flow into the air flow channel 1232 through the second breather hole 1223, and be discharged from the second breather hole 1223, to ensure flow efficiency of the air in the air flow channel 1232, and avoid adverse impact such as obstruction of air flow caused by the first flow-combining plate 121 and the second flow-combining plate 122.

During specific disposition, the condensation tube assembly 123 may have various structure types.

For example, as shown in FIG. 5, FIG. 6, and FIG. 7, in an example provided in this application, the condensation tube assembly 123 includes a plurality of condensation tubes 1233. Each condensation tube 1233 has the condensation channel 1231, and the air flow channel 1232 is formed between two adjacent condensation tubes 1233. Specifically, the condensation tube 1233 is rectangular and plate-shaped, and the condensation channel 1231 runs through two ends (for example, an upper end and a lower end shown in FIG. 6) of the condensation tube 1233 that face away from each other. In other words, the first end opening 12311 of the condensation channel 1231 may be located at one end (for example, the upper end shown in FIG. 6) of the condensation tube 1233, and the second end opening 12312 of the condensation channel 1231 may be located at the other end (for example, the lower end shown in FIG. 6) of the condensation tube 1233. The air flow channel 1232 is formed between two adjacent condensation tubes 1233.

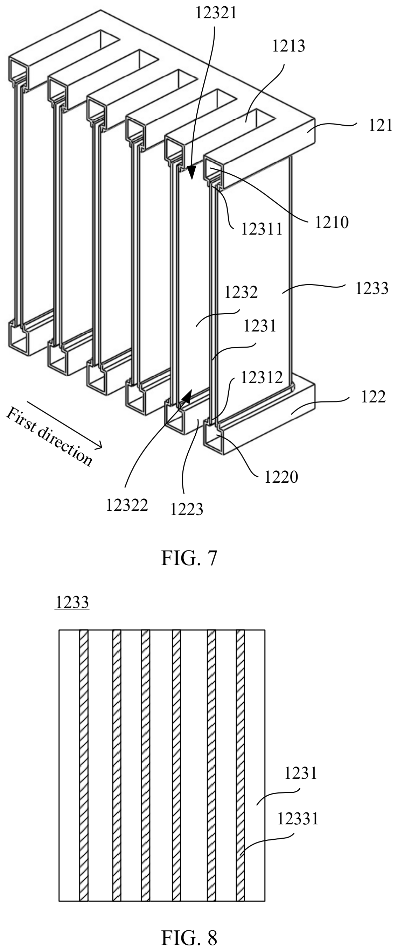

As shown in FIG. 7, in the example provided in this application, the plurality of condensation tubes 1233 are disposed at spacings in a first direction, and the first direction is perpendicular to a plate surface of the condensation tube 1233. The foregoing structure disposition is used, so that there is a large heat exchange area between the condensation tube 1233 and the air flow channel 1232. This helps ensure heat dissipation efficiency of the condensation tube 1233.

In addition, as shown in FIG. 8, during specific disposition, the condensation tube 1233 may further have a plurality of stiffeners 12331 that are parallel to each other and disposed at spacings. Each stiffener 12331 may be connected to two inner walls of the condensation tube 1233 that are disposed opposite to each other. In addition, one end of each stiffener 12331 may extend to the first end opening 12311, and the other end may extend to the second end opening 12312. The stiffeners 12331 are configured to improve structure strength of the condensation tube 1233, to improve a pressure resistance capability of the condensation tube 1233.

In addition, after the stiffeners 12331 are disposed in the condensation channel 1231 of the condensation tube 1233, the stiffeners 12331 divide the condensation channel 1231 into a plurality of channels that are parallel to each other. The stiffeners 12331 are disposed, so that a contact area between the cooling medium and the condensation tube 1233 can increase, and condensation effect of the cooling medium can be improved. During specific disposition, a specific structure, quantity, and position arrangement of stiffeners 12331 may be properly selected and adjusted according to an actual requirement. This is not limited in this application.

During manufacturing of the condensation tube 1233, the condensation tube 1233 may be manufactured by using a process such as plate bending or welding, or may be manufactured in a manner used to prepare a profile such as hot pressing, cold drawing, cold extrusion, or hot extrusion. A specific process for manufacturing the condensation tube 1233 is not limited in this application.

In addition, in another example, a cross section of the condensation tube 1233 may be in a circular, elliptical, polygonal, or another irregular shape. During actual application, a specific shape of the condensation tube 1233 may be properly selected and set according to an actual requirement. Details are not described herein.

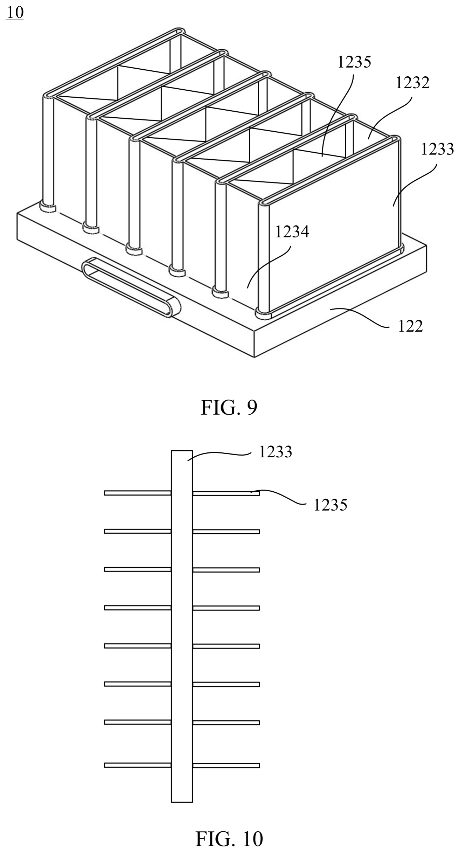

As shown in FIG. 9, in an example provided in this application, the condensation tube assembly 123 further includes a sealing plate 1234, and the sealing plate 1234 is located between two adjacent condensation tubes 1233. An extension direction of the sealing plate 1234 is parallel to the extension direction of the air flow channel 1232. One end of the sealing plate 1234 extends to the first air vent 12321, and the other end extends to the second air vent 12322, so that the two adjacent condensation tubes 1233 and the sealing plate 1234 can jointly form a closed air flow channel 1232, to ensure flow effect of airflow.

In addition, in another example, the condensation tube assembly 123 may alternatively be another mechanical part having a condensation channel 1231 and an air flow channel 1232. A specific structure form of the condensation tube assembly 123 is not limited in this application.

As shown in FIG. 9, in an example provided in this application, the air flow channel 1232 further has a heat dissipation fin 1235, and the heat dissipation fin 1235 is located in the air flow channel 1232 and connected to an outer surface of the condensation tube 1233. Heat of the condensation tube 1233 can be effectively transferred to the heat dissipation fin 1235 through heat conduction. The heat dissipation fin 1235 has a large heat exchange area, and air flowing through a cooling channel can quickly take away heat of the heat dissipation fin 1235, so that condensation efficiency of the cooling medium in the condensation channel 1231 can be effectively improved.

During actual application, the heat dissipation fin 1235 may be fastened between two adjacent condensation tubes 1233, so that integration and structure strength of the condensation tube assembly 123 can be effectively improved. During actual application, the condensation tube assembly 123 may be used as a whole to be assembled between the first flow-combining plate 121 and the second flow-combining plate 122, which can effectively improve convenience of assembly.

During specific disposition, the heat dissipation fin 1235 may have various structure types.

For example, as shown in FIG. 9, the heat dissipation fin 1235 may be of a bent sheet-like structure.

Alternatively, as shown in FIG. 10, the heat dissipation fin 1235 may be of a flat sheet-like structure.

During actual application, the heat dissipation fin 1235 may be independently manufactured and formed, and then fastened to the condensation tube 1233 in a manner such as welding.

Alternatively, the heat dissipation fin 1235 and the condensation tube 1233 may be integrally formed.

During actual application, a specific structure type and a manufacturing manner of the heat dissipation fin 1235 may be properly selected and adjusted. Details are not described herein.

During specific application, the evaporator 11 and the condenser 12 may have various connection manners and relative positions.

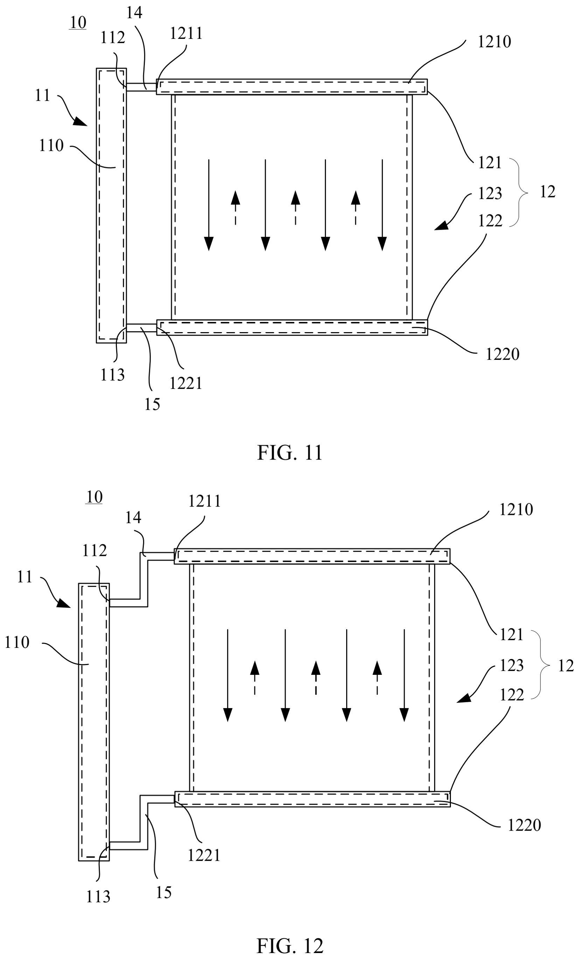

For example, as shown in FIG. 11, in an example provided in this application, the evaporator 11 and the condenser 12 may be connected to each other through a tube, to implement fixed connection between the evaporator 11 and the condenser 12 and communication between paths of the cooling medium.

Specifically, the first flow-combining chamber 1210 has the first flow-combining opening 1211, and the second flow-combining chamber 1220 has the second flow-combining opening 1221. The heat apparatus 10 further includes a first connection tube 14 and a second connection tube 15. One end of the first connection tube 14 is aligned with and communicates with the first flow-combining opening 1211, and the other end is aligned with and communicates with the gas discharge opening 112. One end of the second connection tube 15 is aligned with and communicates with the second flow-combining opening 1221, and the other end is aligned with and communicates with the liquid return opening 113. In other words, the first connection tube 14 can implement fixed connection between the evaporator 11 and the first flow-combining plate 121 and communication between the evaporation chamber 110 and the first flow-combining chamber 1210.

In the example shown in FIG. 11, the first flow-combining opening 1211 and the gas discharge opening 112 may be approximately located on a same horizontal plane, and the second flow-combining opening 1221 and the liquid return opening 113 may be approximately located on a same horizontal plane.

In addition, as shown in FIG. 12, in another example provided in this application, a position of the first flow-combining opening 1211 may be higher than that of the gas discharge opening 112, and a position of the second flow-combining opening 1221 may be higher than that of the liquid return opening 113. The foregoing position layout is used, so that flow efficiency of the cooling medium can be effectively improved. Specifically, after vaporizing in the evaporation chamber 110, the cooling medium naturally flows upward, and is discharged from the gas discharge opening 112. Because the position of the first flow-combining opening 1211 is higher than that of the gas discharge opening 112, the vaporized cooling structure can quickly flow to the first flow-combining opening 1211. This helps the vaporized cooling medium flow from the evaporation chamber 110 to the first flow-combining chamber 1210. In addition, the cooling medium in the second flow-combining chamber 1220 tends to flow downward under effect of gravity. Because the position of the liquid return opening 113 is lower than that of the second flow-combining opening 1221, the cooling medium can quickly flow to the liquid return opening 113 after being discharged from the second flow-combining opening 1221. This helps the liquid cooling medium flow from the second flow-combining chamber 1220 to the evaporation chamber 110.

In another example, the evaporator 11 may alternatively be connected to the condenser 12 directly, to avoid use of a connection tube between the evaporator 11 and the condenser 12, and help reduce manufacturing costs of the heat apparatus 10 and facilitate installation.

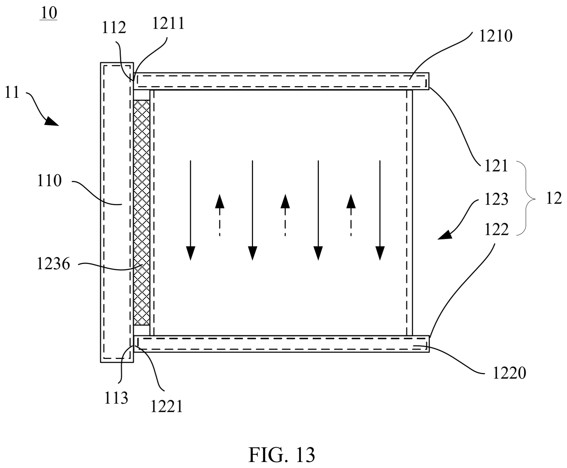

For example, as shown in FIG. 13, in an example provided in this application, the first flow-combining opening 1211 is aligned with and communicates with the gas discharge opening 112 directly, and the second flow-combining opening 1221 is aligned with and communicates with the liquid return opening 113 directly.

In addition, as shown in FIG. 13, in the example provided in this application, the condensation tube assembly 123 has an extension section 1236 disposed toward the evaporator 11, and the extension section 1236 is in heat-conducting contact with the evaporator 11. The extension section 1236 is used, so that heat of the evaporator 11 can be conducted to the condensation tube assembly 123 through heat transfer, and heat dissipation efficiency of the evaporator 11 can be effectively improved.

During specific disposition, the extension section 1236 may be an independent mechanical part such as an aluminum plate or a copper plate. One end of the extension section 1236 may be fastened to the evaporator 11, and the other end may be fastened to a structure such as a condensation tube 1233 or a heat dissipation fin 1235 in the condensation tube assembly 123. Alternatively, in some examples, the extension section 1236 is integrated with the condensation tube assembly 123, or the extension section 1236 may be integrated with the evaporator 11.

During actual application, a specific material, structure shape, and disposition manner of the extension section 1236 may be flexibly selected and adjusted according to an actual requirement. Details are not described herein.

It may be understood that, the foregoing example in which the extension direction of the condensation channel 1231 is parallel to the extension direction of the air flow channel 1232 is used for description. However, during actual application, the condensation channel 1231 may alternatively be perpendicular to the air flow channel 1232. In other words, a direction in which air flows in the air flow channel 1232 may be perpendicular to a direction in which the cooling medium flows in the condensation channel 1231.

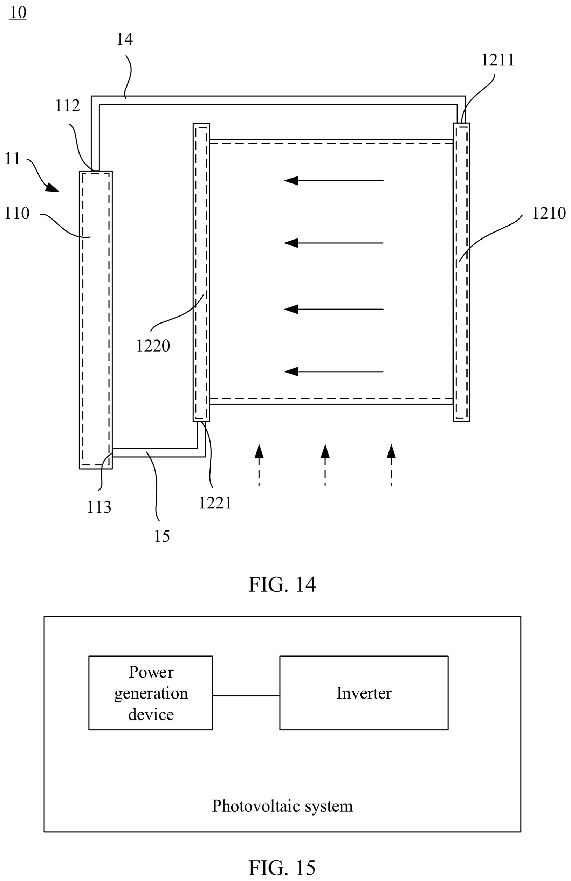

Refer to FIG. 14 and FIG. 12. In an example in FIG. 14, it may be considered that, on the basis of FIG. 12, the condenser 12 is rotated by 90°, and the position of the second flow-combining opening 1221 and structures such as the air flow channel 1232, the first connection tube 14, and the second connection tube 15 are adaptively adjusted.

During specific disposition, an attitude of the condenser 12 may be flexibly adjusted according to an actual requirement, to have good applicability.

During actual application, the inverter 20 may be used in a plurality of scenarios in which electric energy needs to be adjusted and controlled.

For example, as shown in FIG. 15, an embodiment of this application further provides a photovoltaic system, which may include a photovoltaic power generation device and an inverter. The inverter may be connected to the photovoltaic power generation device, and is configured to effectively process electric energy generated by the photovoltaic power generation device to output the electric energy to the outside.

During actual application, the photovoltaic power generation device may be specifically a solar panel, the solar panel may generate a direct current, and the inverter may convert the direct current generated by the solar panel into an alternating current and then output the alternating current to the outside.

Certainly, in another example, the photovoltaic system may further include a battery, a battery management system, and the like. In addition, during actual application, the inverter may be used in a plurality of scenarios in which electric energy needs to be adjusted and controlled. A specific application scenario of the inverter is not limited in this application.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

In this application, "a plurality of' means two or more than two. "And/or" describes an association relationship between associated objects and indicates that three relationships may exist. For example, A and/or B may indicate the following cases: Only A exists, both A and B exist, and only B exists, where A and B may be singular or plural.

It may be understood that various numbers in embodiments of this application are merely used for differentiation for ease of description, and are not used to limit the scope of embodiments of this application. Sequence numbers of the foregoing processes do not mean execution sequences, and the execution sequences of the processes should be determined based on functions and internal logic of the processes.

## Claims

1. An inverter, comprising a circuit board, a power module, and a heat apparatus, wherein the power module is disposed on the circuit board;
the heat apparatus comprises an evaporator, a condenser, and a cooling medium, and a heat-conducting surface of the evaporator is in contact with a side that is of the power module and that faces away from the circuit board;
the evaporator has an evaporation chamber, a gas discharge opening, and a liquid return opening, and the gas discharge opening and the liquid return opening communicate with the evaporation chamber;
the condenser comprises a condensation tube assembly, the condensation tube assembly has a condensation channel and an air flow channel, the cooling medium is in the evaporation chamber and the condensation channel, and the air flow channel is configured to provide a channel for external air;
the condensation channel has a first end opening and a second end opening that face away from each other, the condensation channel extends from the first end opening to the second end opening, the gas discharge opening communicates with the first end opening, and the liquid return opening communicates with the second end opening; and
the air flow channel has a first air vent and a second air vent that face away from each other, the air flow channel extends from the first air vent to the second air vent, the first end opening and the first air vent are located on a first side of the condensation tube assembly, the second end opening and the second air vent are located on a second side of the condensation tube assembly, an extension direction of the condensation channel is parallel to an extension direction of the air flow channel, and the heat-conducting surface of the evaporator is parallel to the extension direction of the condensation channel and the extension direction of the air flow channel.

2. The inverter according to claim 1, wherein the condensation tube assembly comprises a plurality of condensation tubes disposed at spacings, each condensation tube has the condensation channel, and the air flow channel is formed between two adjacent condensation tubes.

3. The inverter according to claim 2, wherein the condensation tube is rectangular and plate-shaped, and the condensation channel runs through two ends of the condensation tube that face away from each other; and
the plurality of condensation tubes are disposed at spacings in a first direction, and the first direction is perpendicular to a plate surface of the condensation tube.

4. The inverter according to claim 2 or 3, wherein the condensation tube assembly further comprises a sealing plate, the sealing plate is located between two adjacent condensation tubes, one end of the sealing plate extends to the first air vent, and the other end extends to the second air vent.

5. The inverter according to any one of claims 2 to 4, wherein the condenser further comprises a first flow-combining plate, and the first flow-combining plate is disposed on the first side of the condensation tube assembly; and
the first flow-combining plate has a first flow-combining chamber, a first flow-combining opening, and a plurality of first flow-dividing openings, the first flow-combining opening communicates with the gas discharge opening, the plurality of first flow-dividing openings are aligned with and communicate with the plurality of first end openings in a one-to-one correspondence, and the first flow-combining opening and the first flow-dividing openings communicate with the first flow-combining chamber.

6. The inverter according to claim 5, wherein the first flow-combining plate further has a first breather hole that runs through a thickness of the first flow-combining plate, and the first air vent of the air flow channel is aligned with and communicates with the first breather hole.

7. The inverter according to claim 5 or 6, wherein the gas discharge opening is aligned with and communicates with the first flow-combining opening.

8. The inverter according to claim 5 or 6, wherein the heat apparatus further comprises a first connection tube, one end of the first connection tube is aligned with and communicates with the gas discharge opening, and the other end is aligned with and communicates with the first flow-combining opening.

9. The inverter according to any one of claims 2 to 8, wherein the condenser further comprises a second flow-combining plate, and the second flow-combining plate is disposed on the second side of the condensation tube assembly; and
the second flow-combining plate has a second flow-combining chamber, a second flow-combining opening, and a plurality of second flow-dividing openings, the second flow-combining opening communicates with the liquid return opening, the plurality of second flow-dividing openings are aligned with and communicate with the plurality of second end openings in a one-to-one correspondence, and the second flow-combining opening and the second flow-dividing openings communicate with the second flow-combining chamber.

10. The inverter according to claim 9, wherein the second flow-combining plate further has a second breather hole that runs through a thickness of the second flow-combining plate, and the second air vent of the air flow channel is aligned with and communicates with the second breather hole.

11. The inverter according to claim 9 or 10, wherein the liquid return opening is aligned with and communicates with the second flow-combining opening.

12. The inverter according to claim 9 or 10, wherein the heat apparatus further comprises a second connection tube, one end of the second connection tube is aligned with and communicates with the liquid return opening, and the other end is aligned with and communicates with the second flow-combining opening.

13. The inverter according to any one of claims 1 to 12, wherein the evaporator comprises the heat-conducting surface, the evaporator is in contact with the power module through the heat-conducting surface, a capillary structure is disposed in the evaporation chamber, and a projection of the capillary structure covers the heat-conducting surface.

14. The inverter according to any one of claims 2 to 13, wherein the condensation tube assembly further has a heat dissipation fin, and the heat dissipation fin is located in the air flow channel and connected to an outer surface of the condensation tube.

15. The inverter according to any one of claims 1 to 14, wherein the condensation tube assembly has an extension section disposed toward the evaporator, and the extension section is in heat-conducting contact with the evaporator.

16. The inverter according to any one of claims 1 to 15, wherein the heat apparatus further comprises a fan, and the fan is disposed on a first side and/or a second side of the condenser.

17. A heat apparatus, comprising an evaporator, a condenser, and a cooling medium, wherein
the evaporator has an evaporation chamber, a gas discharge opening, and a liquid return opening, and the gas discharge opening and the liquid return opening communicate with the evaporation chamber;
the condenser comprises a condensation tube assembly, the condensation tube assembly has a condensation channel and an air flow channel, the cooling medium is in the evaporation chamber and the condensation channel, and the air flow channel is configured to provide a channel for external air;
the condensation channel has a first end opening and a second end opening that face away from each other, the condensation channel extends from the first end opening to the second end opening, the gas discharge opening communicates with the first end opening, and the liquid return opening communicates with the second end opening; and
the air flow channel has a first air vent and a second air vent that face away from each other, the air flow channel extends from the first air vent to the second air vent, the first end opening and the first air vent are located on a first side of the condensation tube assembly, the second end opening and the second air vent are located on a second side of the condensation tube assembly, and an extension direction of the condensation channel is parallel to an extension direction of the air flow channel.
